# EUROPEAN PATENT APPLICATION

(11) **EP 1 887 371 A1**
(43) Date of publication of application: **13.02.2008**
(21) Application number: 06746210.1
(22) Date of filing: 10.05.2006
(51) Int. Cl.: G01R 33/07

(54) **SENSOR**

(30) Priority: 13.05.2005 JP 2005141862
(71) Applicant: Tyco Electronics AMP K.K., Kawasaki-shi, Kanagawa 213-8535 (JP)
(72) Inventor: OKAZAKI, Hiroyuki, 2138535 (JP); AZUMA, Yugho, 2138535 (JP); MINEMATSU, Takayuki, 2138535 (JP)
(74) Representative: Johnstone, Douglas Ian
(86) International application number: PCT/JP2006/309396
(87) International publication number: WO 2006/121072

(57) **Abstract**

[PROBLEMS] In a sensor provided with a Hall element in a housing, the Hall element is arranged exactly in the nonflux region of a U-shaped magnet. [MEANS FOR SOLVING PROBLEMS] The sensor comprises a U-shaped magnet (50) having a pair of portions (51) opposing each other through an interval with a nonflux region A being formed between them, a Hall element (80) producing an output voltage depending on the density of passing flux, a spacer (40) for regulating positional relation of the Hall element (80) and the U-shaped magnet (50) such that the Hall element (80) is positioned in the nonflux region A of the U-shaped magnet (50), and a housing (10) covering the spacer (40).

## Description

### TECHNICAL FIELD

The present invention relates to a sensor provided with a Hall element in a housing.

### BACKGROUND OF THE TECHNOLOGY

In the past, various sensors have been proposed as non-contact sensors (see Patent document 1, for example), and a sensor provided with a Hall element producing an output voltage variable according to the density of passing magnetic flux has been used to detect the rotational speed of a gear in the automatic transmission of an automobile (see Patent document 2, for example).

In the abovementioned Patent document 2, an electric field is generated by a U-shaped magnet wherein a pair of portions opposing each other and spaced apart corresponds to the linear portions of the U-shape. The U-shaped magnet is a permanent magnet having a flux-free region between the pair of opposing portions, and Patent document 2 proposes providing a Hall element in this flux-free region. By arranging this sensor so that the front tip of the pair of opposing portions of the U-shaped magnet passes alternately past the tip (peak) of a gear tooth and the space between gear teeth (valley) when the gear rotates, the density of flux passing through the Hall element varies, and based on the (frequency) variation in Hall voltage output from the Hall element, the number of gear rotations is obtained.

Here, the U-shaped magnet and Hall element are housed in a housing and used as a sensor, but in order to reduce the difference in output voltage according to the variation in flux density, the Hall element must be arranged precisely in the flux-free region of the U-shaped magnet, and the positional relationship between the U-shaped magnet and the Hall element in the housing becomes extremely crucial. In the past, the sensor was assembled by soldering the Hall element to a circuit board, housing the U-shaped magnet in the housing, and then press-fitting the circuit board to which the Hall element is soldered into the housing.
Patent document 1: Japanese published unexamined patent application H5-342961
Patent document 2: Japanese published unexamined patent application H9-511357

### DISCLOSURE OF THE INVENTION

### PROBLEMS TO BE SOLVED BY THE INVENTION

However, when soldering the Hall element to the circuit board, the positional relationship between the circuit board and the Hall element is easily displaced, and this displacement remains even when the circuit board is press-fitted into the housing, and in some finished conventional sensors the Hall element is arranged at a position displaced from the flux-free region of the U-shaped magnet.

In consideration of the abovementioned circumstances, it is an object of the present invention to provide a sensor in which the Hall element is arranged precisely in the flux-free region of the U-shaped magnet.

### MEANS TO SOLVE THE PROBLEMS

The sensor of the present invention provides a solution for the abovementioned object and is characterized as comprising:
a U-shaped magnet having a pair of opposing portions spaced apart from each another, forming a flux-free region between the pair of opposing portions;
a Hall element that varies an output voltage according to the density of passing flux;
a spacer for regulating the positional relationship between the Hall element and the U-shaped magnet such that the Hall element is positioned in the flux-free region of the U-shaped magnet; and
a housing that covers the spacer.

With the sensor of the present invention, both the Hall element and the U-shaped magnet are positioned by a spacer. Consequently, the Hall element is positioned properly in the non-flux region of the U-shaped magnet, the positional relationship between the Hall element and the U-shaped magnet does not become distorted even when the spacer is installed inside the housing, and a sensor is provided in which the Hall element is arranged precisely in the flux-free region of the U-shaped magnet.

Moreover, in the sensor of the present invention, the spacer preferably has a magnet positioning portion for positioning the surface of a middle portion connecting the pair of opposing portions and facing the flux-free region of the U-shaped magnet, and an element positioning portion for positioning the Hall element.

In the positional relationship between the Hall element and the U-shaped magnet, the positional relationship between the above-described surface of the U-shaped magnet and the Hall element is extremely critical, and provision of the above-described magnet positioning portion is preferable.

Furthermore, in the sensor of the present invention, the spacer preferably has a guiding portion, extending in the horizontal direction in which one portion of the pair of opposing portions faces the other opposing portion, for guiding the Hall element to a predetermined position, and a lift inhibitor for regulating the lift of the Hall element arranged at that predetermined position.

The Hall element easily lifts up during soldering, for example, and by mounting the lift inhibitor on the spacer the Hall element is positioned properly, even in the vertical direction, in the non-flux region of the U-shaped magnet.

### EFFECT OF THE INVENTION

According to the present invention, a sensor can be provided in which the Hall element is arranged precisely in the flux-free region of the U-shaped magnet.

### BEST MODE FOR CARRYING OUT THE INVENTION

A preferred embodiment of the present invention is described below with reference to drawings.

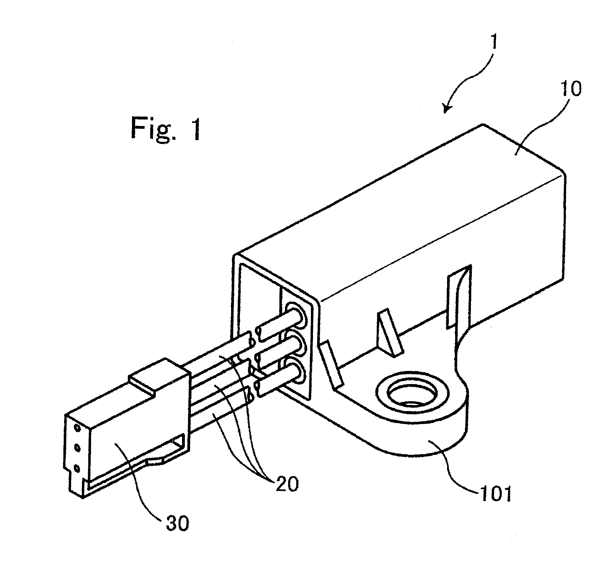

FIG. 1 is a perspective view of a sensor corresponding to one embodiment of the present invention.

A sensor 1 shown in FIG. 1 is for the purpose of detecting the rotational speed of a gear in the automatic transmission of an automobile, and has a housing 10, three wires 20 and a connector 30 that connects the three wires 20. FIG. 1 omits showing the middle portion of the three wires 20. The housing 10 is provided with an attaching portion 101 for mounting the sensor 1 to the frame of the automatic transmission (not shown). Inside the housing 10 is mounted a spacer arranged with a U-shaped magnet at the tip portion of the front surface thereof.

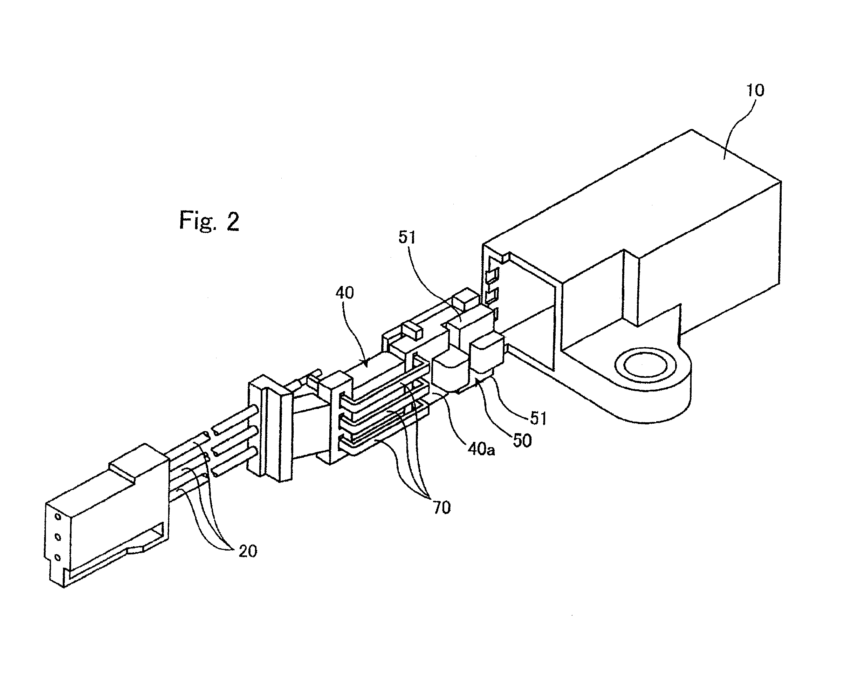

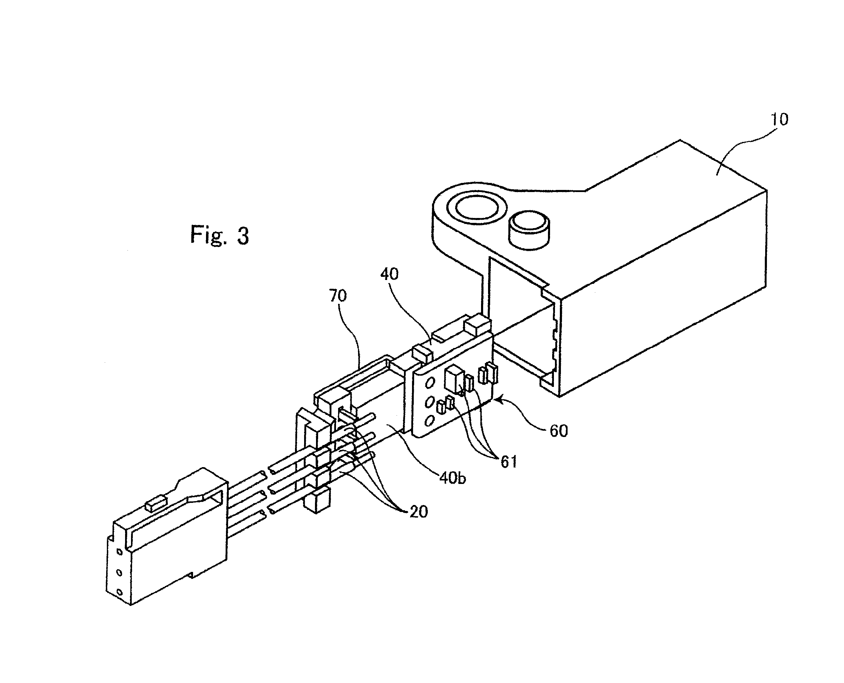

FIG. 2 shows the spacer in the state of having been removed from inside of the housing, in a perspective view as seen from the front surface side on which the U-shaped magnet is arranged, and FIG. 3 is a perspective view as seen from the rear surface side opposite the surface on which the U-shaped magnet is arranged.

At the tip portion of the front surface 40a of the spacer 40 shown in FIG. 2 is arranged the U-shaped (C-shaped) magnet 50, wherein a pair of portions 51 opposing each other and spaced apart correspond to the linear portions of the U-shape. Moreover, at the tip portion of the rear surface 40b of the spacer 40 shown in FIG. 3 is arranged a circuit board 60. The circuit board 60 shown in FIG. 3 is mounted with chip components 61 such as capacitors to suppress noise. Furthermore, FIGS. 2 and 3 show a terminal block 70 that connects each of the three wires 20 to the circuit board 60.

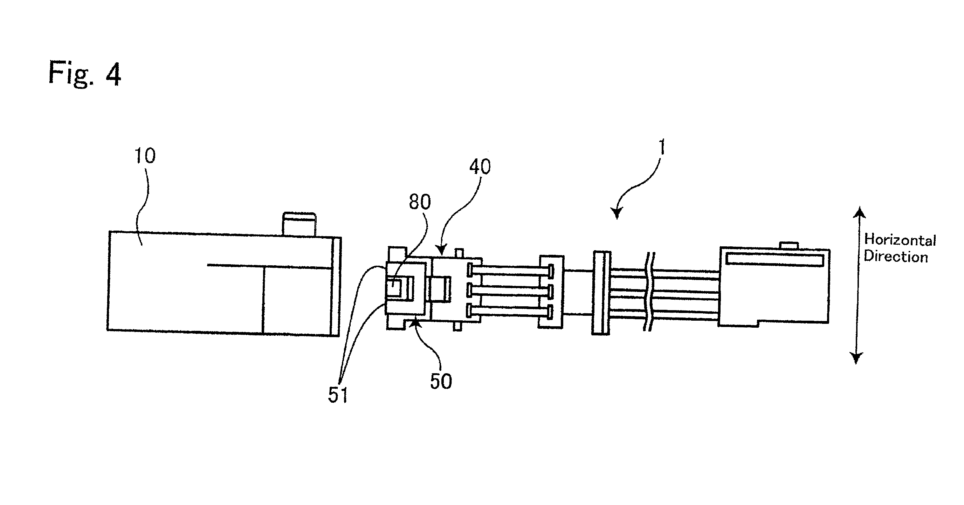

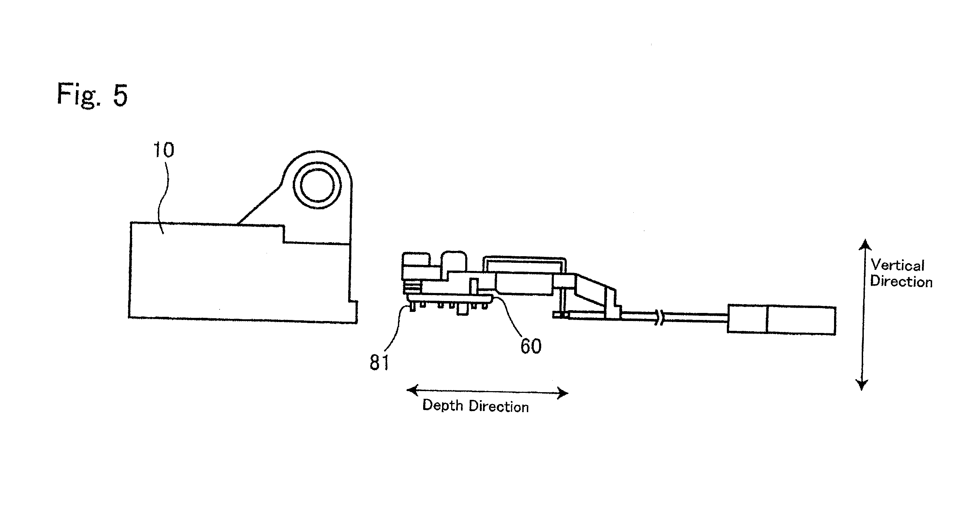

FIG. 4 is a plan view of a sensor wherein the spacer has been pulled out from inside the housing shown in FIG. 2, and FIG. 5 is a side view of the sensor shown in FIG. 4

In FIG. 4, a Hall element 80 is shown between the pair of opposing portions 51 of the U-shaped magnet 50 arranged on the spacer 40. That is, the sensor 1 shown in FIG. 1 is provided with the Hall element 80 producing an output voltage variable according to the density of passing flux. The sensor 1 is arranged such that the tip of the spacer 40 covered by the housing 10 faces the tip of the gear tooth to be detected. By arranging the sensor 1 shown in FIG. 1 in this manner, gear rotation causes the density of flux passing through the Hall element to vary, and the number of gear rotations is detected based on the variation in Hall voltage output from the Hall element.

In the following explanation, the direction in which one of the opposing portions of the pair of opposing portions 51 of the U-shaped magnet 50 faces the other opposing portion thereof is referred to as the horizontal direction.

Moreover, the state in which a terminal 81 of the Hall element 80 is soldered to the circuit board 60 is shown in FIG. 5.

In the following explanation, the direction in which the terminal 81 of the Hall element 80 extends is referred to as the vertical direction, and the direction linking the tip and rear end of the spacer 40 is referred to as the depth direction.

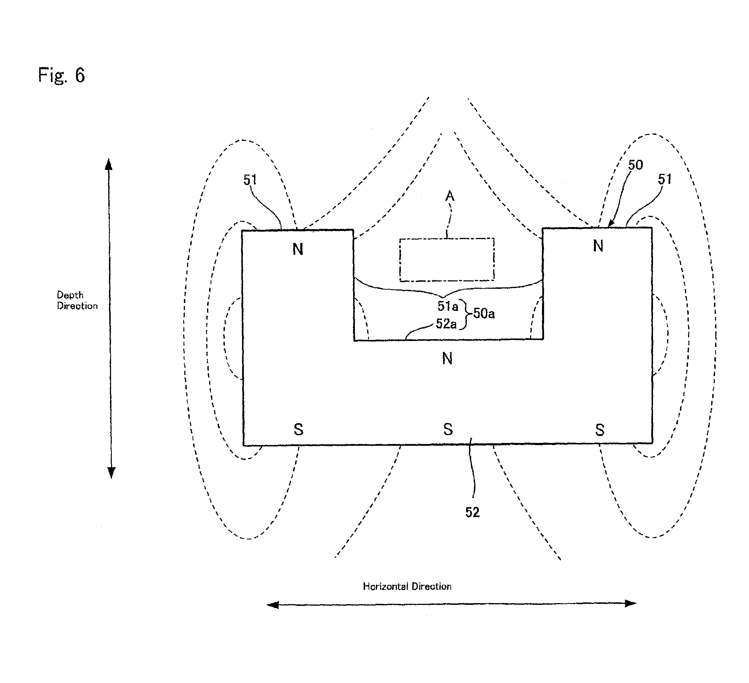

FIG. 6 is a drawing that shows the U-shaped magnet shown in FIG. 2.

In FIG. 6, dotted lines indicate lines of magnet force; the U-shaped magnet 50 shown in FIG. 6 is magnetized as is shown in the drawing, and a flux-free region A is formed between the pair of opposing portions 51. When the U-shaped magnet 50 is arranged on the spacer 40, the tip side of the spacer 40 is located above the drawing. Furthermore, in FIG. 6, the left and right directions in the drawing correspond to the horizontal direction, and the up and down directions in the drawing correspond to the depth direction. In the following explanation, the portion of the U-shaped magnet 50 extending in the horizontal direction and linking the pair of opposing portions 51 is referred to as the middle portion 52. Moreover, a surface comprising surfaces 51 a of the pair of opposing portions 51 facing the flux-free region A and a surface 52a of the middle portion 52 facing the flux-free region A is referred to as an inner circumferential surface 50a of the U-shaped magnet 50.

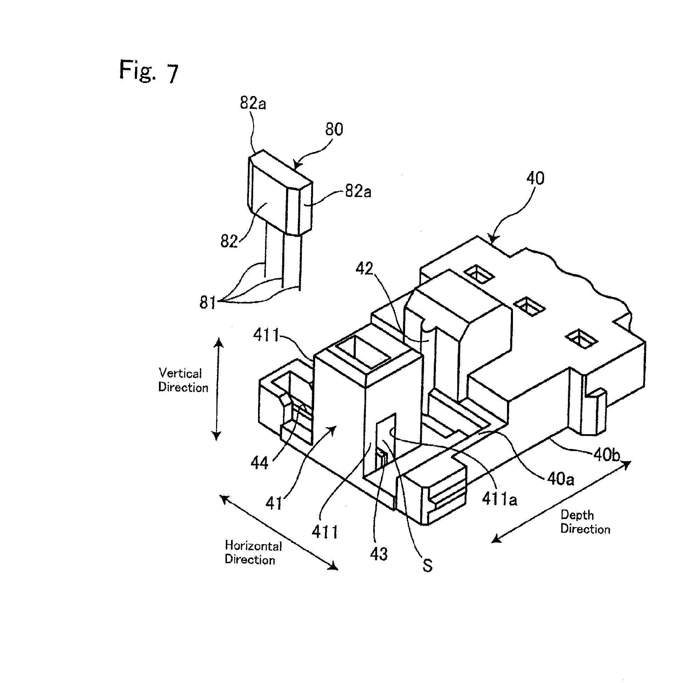

FIG. 7 is a magnified view of the tip portion of the spacer shown in FIGS. 3 to 5.

As explained above, the U-shaped magnet 50, the Hall element 80 and the circuit board 60 are arranged at the tip portion of the spacer 40, and the tip portion of the front spacer 40 that arranges these members is shown in FIG 7. Moreover, the Hall element 80 to be arranged on the spacer 40 is also shown in FIG. 7.

The tip portion of the front surface 40a of the spacer 40 shown in FIG. 7 is provided with a tubular portion 41 surrounding a predetermined space S at the center in the horizontal direction on the front surface 40a. The shape of the perimeter of the tubular portion 41 fits the shape of the inner circumferential surface 50a of the U-shaped magnet 50 (see FIG. 6). Moreover, the tip portion of the front surface 40a of the spacer 40 is also provided with a protruding portion 42 extending in the vertical direction. The protruding portion 42 protrudes towards the tubular portion 41. The middle portion 52 (see FIG. 6) of the U-shaped magnet 50 arranged on the spacer 40 is pressed toward the tubular portion 41 by the protruding portion 41, and the U-shaped magnet is arranged on the spacer 40 in the state where the inner circumferential surface 50a is touching the tubular portion 41. In other words, the surface 52a of the middle portion 52 facing the flux-free region A is positioned properly by the protruding portion 42 and the tubular portion 41. Therefore, the combination of the protruding portion 42 and the tubular portion 41 correspond to one example of the magnet positioning portion of the present invention. The position of the flux-free region A (see FIG. 6) of the U-shaped magnet arranged on the spacer 40 matches the position of the predetermined space S in the tubular portion 41 in the horizontal, vertical and depth directions.

Moreover, the tip portion of the front surface 40a of the spacer 40 shown in FIG. 7 is also provided with a guiding portion 43 extending in the horizontal direction. Each of the horizontally-facing side walls 411 of the tubular portion 41 is provided with a hole 411 slightly larger than the size of the main body 82 of the Hall element 80, and the guiding portion 43 extends from one edge in the horizontal direction of the spacer 40, through a hole provided on one side of a side wall of the tubular portion 41, to the predetermined space S. Additionally, the spacer 40 is also provided, along the guiding portion 43, with a long hole 44 through the front surface 40a and the rear surface 40b. In the state where the terminal 81 protrudes from the long hole 44 to the rear surface side 40b, the Hall element 80 is guided by the guiding portion 43 so that the main body 82 arrives at the predetermined space S. The horizontal length of the tubular portion 41 matches the horizontal length of the main body 82, and the horizontally-facing side surfaces 82a of the main body 82, having arrived at the predetermined space S, are each at the same positions as the perimeter surfaces of each of the horizontally-facing side walls 411 of the tubular portion 41.

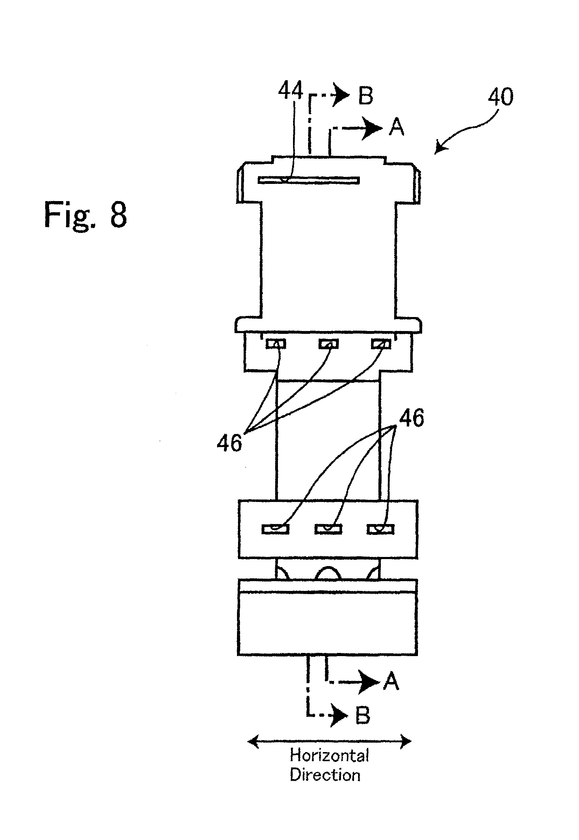

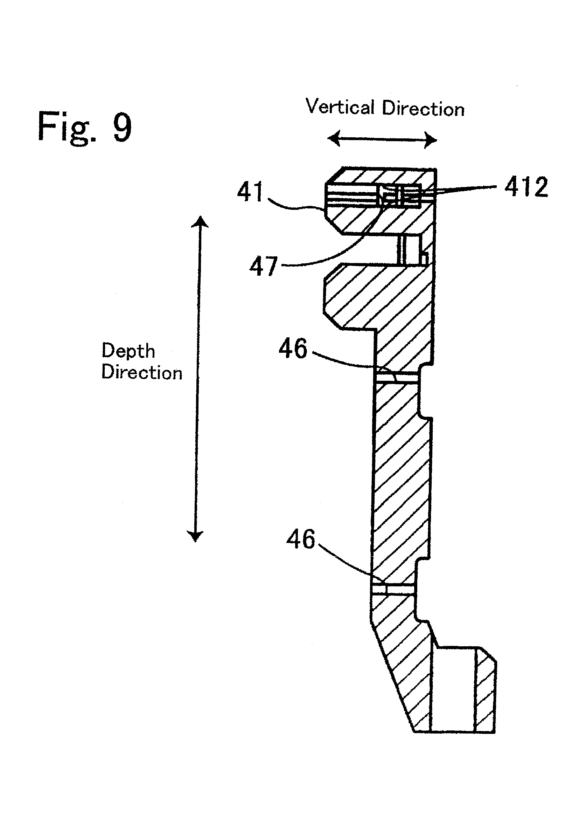

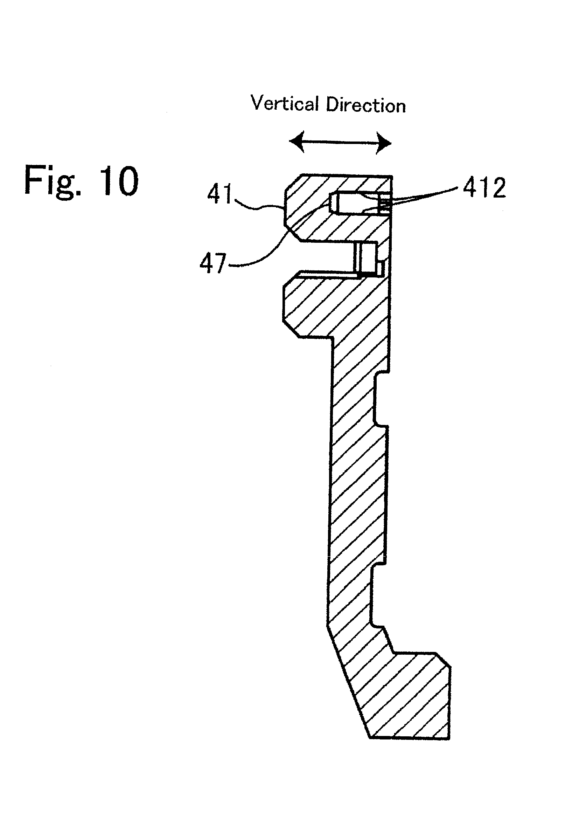

FIG. 8 is a bottom view of the entire spacer of FIG. 7 and shows the tip portion thereof. Moreover, FIG. 9 is a cross-sectional view of A-A in FIG. 8, and FIG. 10 is a cross-sectional view of B-B in FIG. 8. In other words, FIG. 9 shows the appearance of a cross section of the spacer 40 at the center in the horizontal direction, and FIG. 10 shows the appearance of a cross section of the spacer 40 at a position slightly displaced from the center in the horizontal direction.

In both of these drawings, the tip of the spacer 40 is located at the top of the drawing. FIG. 8 shows the long hole 44 provided along the guiding portion 43. Moreover, FIGS. 8 and 9 show a hole 46 into which is inserted both ends of the terminal block 70 linking the circuit board 60 and the three wires 20 shown in FIG. 2 and other drawings. Additionally, FIGS. 9 and 10 show the tubular portion 41, and also show depth-direction-facing walls 412 that regulate the predetermined space S inside the tubular portion 41.

Here, denoting the vertical-direction front surface side 40a (left side in FIGS. 9 and 10) as the top and the rear surface 40b side (right side in FIGS. 9 and 10) as the bottom, a comparison of FIGS. 9 and 10 reveals that the top side of the predetermined space S is open in FIG. 9, but is closed in FIG. 10. In other words, a lift inhibitor 47 for regulating the lift of the Hall element arranged at the predetermined space S is provided above both horizontal sides of the predetermined space S in the tubular portion 41.

Next, the procedure for assembling the sensor 1 shown in FIG. 1 is explained.

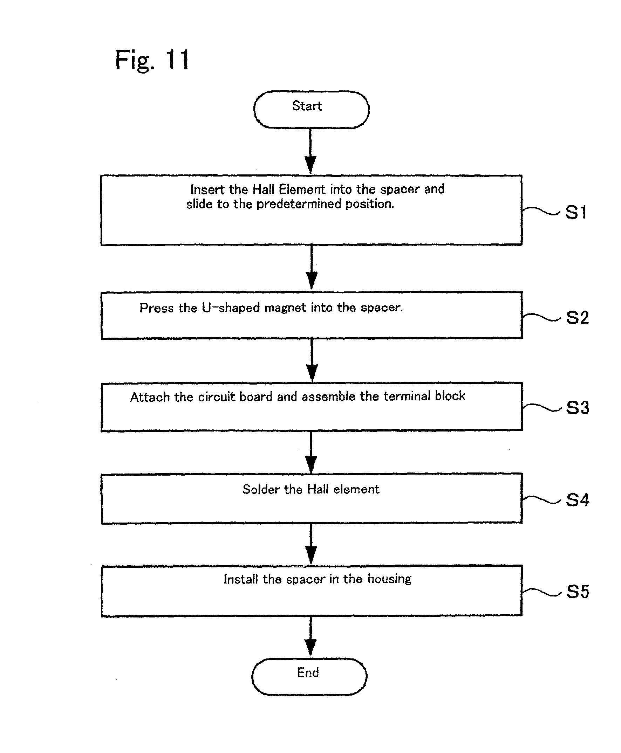

FIG. 11 is a flowchart showing the assembly procedure of the sensor 1 shown in FIG. 1.

First, in the state where the terminal 81 protrudes from the long hole 44 to the rear surface 40b side, the Hall element is inserted at one edge in the horizontal direction of the spacer 40 at the guiding portion 43 of the spacer 40 shown in FIG. 7, and the Hall element 80 is slid horizontally toward the predetermined space S (step S1). The Hall element 80 is guided by the guiding portion 43, and the main body 82 arrives inside the tubular portion 41.

Next, from above the tubular portion 41, the U-shaped magnet 50 is pressed into the tubular portion 41 along the inner circumferential surface 50a (step S2). As described above, the U-shaped magnet 50 is pressed against the tubular portion 41 by the protruding portion 42, and arranged in the spacer 40 in a press-fitted state. Thus, the U-shaped magnet 50 arranged in the spacer 40 is positioned properly. Moreover, when the U-shaped magnet 50 is pressed from above, even if, as a result of performing the prior step S1, one of the side surfaces 82a of the main body 82 of the Hall element 80 having arrived inside the tubular portion 41 protrudes in the horizontal direction from the hole 411a of the tubular portion 41, the protruding side surface 82a is pressed in the direction opposite the protrusion direction by the U-shaped magnet 50 pressed from above, and in the horizontal direction, the main body 82 is housed properly in the tubular portion 41. Moreover, the main body 82, having arrived in the tubular portion 41, is sandwiched by the depth-direction-facing walls 412 that regulate the predetermined space S inside the tubular portion 41 (see FIGS. 9 and 10), and also in the depth direction, the main body 82 is housed properly in the tubular portion 41. Additionally, the lift-up of the main body 82, having arrived inside the tubular portion 41, is regulated by a lift inhibitor 47 (see FIGS. 9 and 10). Therefore, the Hall element 80 is positioned properly in the predetermined space S in the tubular portion 41, and the tubular portion 41 corresponds to one example of the element positioning portion of the present invention. As described above, the position of the flux-free region A (see FIG. 6) of the U-shaped magnet 50 arranged on the spacer 40 matches the position of the predetermined space S in the tubular portion 41 in the horizontal, vertical and depth directions, and therefore the Hall element 80 is positioned properly in the flux-free region A of the U-shaped magnet 50.

Then, the circuit board 60 mounted with chip components 61 is attached to the rear surface 40b of the spacer 40, and the terminal block 70 shown in FIG. 7 is assembled on the spacer 40 (step 3).

Next, the terminal 81 of the Hall element 80 and the terminal block 70 shown in FIG. 7 are soldered to the circuit board 60 (step 4). This flow soldering is performed in a batch process by flowing the solder to solder the terminal 81 and the terminal block 70. The use of a solder flow increases the assembling efficiency. Moreover, when flow soldering, a force is applied that would have the effect of moving the Hall element 80 upward, but the Hall element 80 is prevented from lifting up by the lift inhibitor 47 (see FIGS. 9 and 10), and remains in the predetermined space S.

Lastly, after completion of the processing through step S4, in the state where the end of the terminal block 70 opposite the end soldered to the circuit board 60 is connected to the wires 20 connected by the connector 30, the spacer 40 is additionally installed inside the housing 10 (step 5). Here, adhesive is poured into the housing 10 to affix the spacer 40 inside the housing 10.

By following the above-described procedure, the sensor 1 shown in FIG. 1 is completed; and because the positional relationship between the Hall element 80 and the U-shaped magnet 50 does not become distorted even when the spacer 40 is installed inside the housing 10, and because the Hall element 80 is arranged precisely in the flux-free region A of the U-shaped magnet 50 in the completed sensor 1, difference in sensor performance can be reduced.

### BRIEF DESCRIPTION OF THE DRAWINGS

FIG. 1 is a perspective view of a sensor corresponding to an embodiment of the present invention.
FIG. 2 is a perspective view showing the spacer in the state of having been removed from inside of the housing, as seen from the front surface side on which the U-shaped magnet is arranged.
FIG. 3 is a perspective view of the state shown in FIG. 2, as seen from the rear surface side opposite the surface on which the U-shaped magnet is arranged.
FIG. 4 is a plan view of a sensor wherein the spacer has been pulled out from inside the housing shown in FIG. 2.
FIG. 5 is a side view of the sensor shown in FIG. 4
FIG. 6 is a drawing of the U-shaped magnet shown in FIG. 2.
FIG. 7 is a magnified view of the tip portion of the spacer shown in FIGS. 3 to 5.
FIG. 8 is a bottom view of the entire spacer of FIG. 7 and shows the tip portion thereof.
FIG. 9 is a drawing of the A-A cross-section of FIG. 8.
FIG. 10 is a drawing of the B-B cross-section of FIG. 8.
FIG. 11 is a flowchart showing the assembly procedure for the sensor.

### DESCRIPTION OF REFERENCE NUMERALS

- 1: Sensor
- 10: Housing
- 20: Wire
- 30: Connector
- 40: Spacer
- 41: Tubular portion
- 42: Protruding portion
- 43: Guiding portion
- 47: Lift inhibitor
- 50: U-shaped magnet
- A: Flux-free region
- 51: Opposing portion
- 52: Middle portion
- 60: Circuit board
- 70: Terminal block
- 80: Hall element

## Claims

1. A sensor comprising:
a U-shaped magnet having a pair of opposing portions spaced apart from each another, forming a flux-free region between the pair of opposing portions;
a Hall element that varies an output voltage according to the density of passing magnetic flux;
a spacer for regulating the positional relationship between the Hall element and the U-shaped magnet such that the Hall element is positioned in the flux-free region of the U-shaped magnet; and
a housing that covers the spacer.

2. The sensor cited in Claim 1, wherein the spacer comprises a magnet positioning portion for positioning the surface of a middle portion connecting the pair of opposing portions and facing the flux-free region of the U-shaped magnet, and an element positioning portion for positioning the Hall element.

3. The sensor cited in Claim 1, wherein the spacer comprises a guiding portion, extending in the horizontal direction in which one portion of the pair of opposing portions faces the other opposing portion, for guiding the Hall element to a predetermined position, and a lift inhibitor for regulating the lift of the Hall element arranged at that predetermined position.
